# EUROPEAN PATENT APPLICATION

(11) **EP 4 645 202 A1**
(43) Date of publication of application: **05.11.2025**
(21) Application number: 24760572.8
(22) Date of filing: 21.02.2024
(51) Int. Cl.: G06Q 50/04, G06Q 50/10, G01R 31/385, H01M 10/04, G05B 19/418, G06K 19/06, G06K 7/14

(54) **SERVER AND METHOD OF OPERATING SERVER**

(30) Priority: 24.02.2023 KR 20230025410; 29.01.2024 KR 20240013253
(71) Applicant: LG Energy Solution, Ltd., Seoul 07335 (KR)
(72) Inventor: YANG, Byung Taek, Daejeon 34122 (KR)
(74) Representative: BCKIP Part mbB
(86) International application number: PCT/KR2024/002270
(87) International publication number: WO 2024/177383

(57) **Abstract**

A server according to one embodiment disclosed herein includes a communication unit configured to receive first data including first identification information and physical property information of a battery cell from a first device included in a first process in a process of manufacturing the battery cell, and receive second data including second identification information of the battery cell from a second device included in a second process which differs from the first process, and a controller configured to identify the first data corresponding to the second data based on the first identification information and the second identification information, and transmit the first data to the second device.

## Description

### [TECHNICAL FIELD]

### CROSS-REFERENCE TO RELATED APPLICATION

This application claims priority to and the benefit of Korean Patent Applications Nos. 10-2023-0025410 and 10-2024-0013253 filed in the Korean Intellectual Property Office on February 24, 2023 and January 29, 2024, respectively, the entire contents of which are incorporated herein by reference.

### TECHNICAL FIELD

Embodiments disclosed herein relate to a server and a method of operating the server.

### [BACKGROUND ART]

Recently, as demand for portable electronic products such as laptops, video cameras, and portable phones increases rapidly, and as the development of electric vehicles, energy storage batteries, robots, satellites, and the like begins in earnest, the research on high-performance batteries capable of repeated charging and discharging is actively being conducted.

A manufacturing process of a battery generally includes an electrode process, an assembly process, an activation process, and a pack process. Since each process may be performed in a different position, a means for identifying battery cells being manufactured and conveying information about the battery cells is needed. To this end, two-dimensional (2D) barcodes are printed on surfaces of the battery cells, and the 2D barcodes are identified in the next process to identify the battery cells and convey the information about the battery cells.

However, additional costs and time may be required and productivity may decrease due to the printing of the 2D barcodes on the surfaces of the battery cells and rework due to defective 2D barcodes.

### [DISCLOSURE]

### [TECHNICAL PROBLEM]

Embodiments disclosed herein provide a server for efficiently managing information about battery cells, and a method of operating the server.

The objects of the embodiments disclosed herein are not limited to the above-described objects, and other objects that are not mentioned will be able to be clearly understood by those skilled in the art from the following description.

### [TECHNICAL SOLUTION]

A server according to one embodiment disclosed herein includes a communication unit configured to receive first data including first identification information and physical property information of a battery cell from a first device included in a first process in a process of manufacturing the battery cell, and receive second data including second identification information of the battery cell from a second device included in a second process which differs from the first process, and a controller configured to identify the first data corresponding to the second data based on the first identification information and the second identification information, and transmit the first data to the second device.

According to one embodiment, the controller may determine that the second data corresponds to the first data when the second identification information and the first identification information are the same.

According to one embodiment, the second device may acquire the second identification information by recognizing an identification mark included in the battery cell.

According to one embodiment, the identification mark may be a 1-dimensional (1D) barcode.

According to one embodiment, the second device may acquire the physical property information by receiving data from the communication unit.

According to one embodiment, the first identification information may include an identification number of the battery cell, and the physical property information may include an open-circuit voltage (OCV) and capacity of the battery cell.

According to one embodiment, the second identification information may include the identification number of the battery cell.

According to one embodiment, the controller may generate a database including the first data, transmit the first data including the first identification information to the second device when the database includes the first identification information corresponding to the second identification information, and transmit a loss signal to the second device when the database does not include the first identification information corresponding to the second identification information.

According to one embodiment, the first process may be an assembly process or an activation process, and the second process may be a pack process.

According to one embodiment, the server may further include a storage configured to store the first data.

A method of manufacturing a battery according to one embodiment disclosed herein includes receiving first data including first identification information and physical property information of a battery cell from a first device included in a first process in a process of manufacturing the battery cell, receiving second data including second identification information and physical property information of the battery cell from a second device included in a second process which differs from the first process, and transmitting the first data corresponding to the second data to the second device.

According to one embodiment, the method may further include identifying the first data corresponding to the second data.

According to one embodiment, the identifying may include determining that the second data corresponds to the first data when the second identification number and the first identification number are the same.

According to one embodiment, the second device may acquire the second identification information by recognizing an identification mark included in the battery cell.

According to one embodiment, the identification mark may be a 1-dimensional (1D) barcode.

According to one embodiment, the first identification information may include an identification number of the battery cell, and the physical property information may include an open-circuit voltage (OCV) and capacity of the battery cell.

According to one embodiment, the second identification information may include the identification number of the battery cell.

According to one embodiment, the first process may be an assembly process or an activation process, and the second process may be a pack process.

Detailed matters of other embodiments are included in a detailed description and accompanying drawings.

### [ADVANTAGEOUS EFFECTS]

According to the server and the method of operating the server according to embodiments disclosed herein, it is possible to reduce the time and costs caused by the printing and maintenance of the 2D barcodes, thereby increasing the manufacturing efficiency of the battery.

According to the server and the method of operating the server according to the embodiments disclosed herein, it is possible to efficiently change data conveyed between processes in the process of manufacturing the battery even without changing the 2D barcodes.

### [DESCRIPTION OF DRAWINGS]

FIG.1 is a block diagram showing a system for manufacturing a battery according to one embodiment disclosed herein.
FIG.2 is a view showing a server according to one embodiment disclosed herein.
FIG.3 is a view showing a method in which the server according to one embodiment disclosed herein matches first data with second data.
FIG.4 is a flowchart showing a method of operating the server according to one embodiment disclosed herein.
FIG.5 is a computing system for executing the method of operating the server according to one embodiment disclosed herein.

### [MODE FOR INVENTION]

Hereinafter, embodiments disclosed herein will be described in detail with reference to exemplary drawings. In adding reference numerals to components in each drawing, it should be noted that the same components have the same reference numerals as much as possible even when they are illustrated in different drawings. In addition, in describing embodiments disclosed herein, the detailed description of related known configurations or functions will be omitted when it is determined that the detailed description obscures the understanding of the embodiments disclosed herein.

Terms, such as first and second, can be used to describe components of the embodiments disclosed herein. These terms are only for the purpose of distinguishing one component from another, and the nature, sequence, order, or the like of the corresponding component is not limited by the terms. In addition, unless otherwise defined, all terms (including technical and scientific terms) used herein have the same meanings as those commonly understood by those skilled in the art to which embodiments disclosed herein pertains. The terms defined in a generally used dictionary should be construed as meanings that match with the meanings of the terms from the context of the related technology and are not construed as an ideal or excessively formal meaning unless clearly defined in this application.

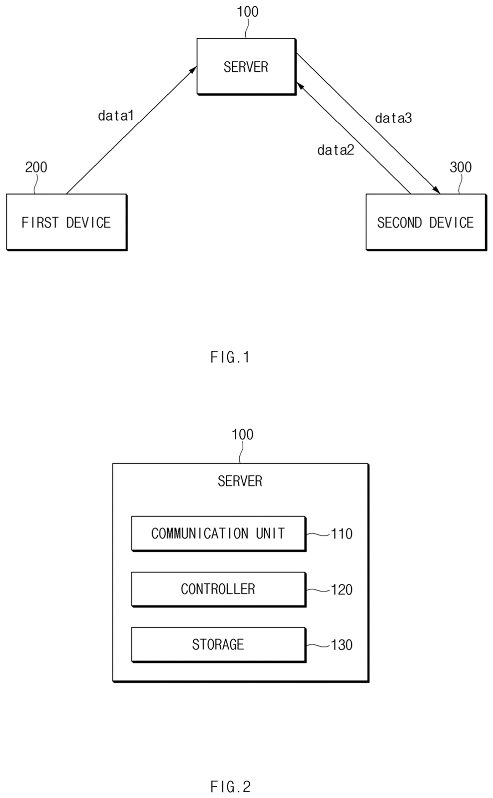

FIG.1 is a block diagram showing a system for manufacturing a battery according to one embodiment disclosed herein.

Referring to FIG.1, a system for manufacturing a battery according to one embodiment disclosed herein may include a server 100, a first device 200, and a second device 300.

The server 100 may receive data from the first device 200. Data received by the server 100 from the first device 200 can be defined as first data data1. The server 100 may receive the first data data1 from the first device 200 and store the first data data1.

The server 100 may receive data from the second device 300. Data received by the server 100 from the second device 300 can be defined as second data data2. The server 100 may receive data from the second device 300. According to the embodiment, the server 100 may include a cloud server 100, but is not limited thereto.

The first device 200 may include a device for manufacturing a battery. A process of manufacturing the battery may include an electrode process, an assembly process, an activation process, and a pack process.

The electrode process may be a process of forming positive (+) and negative (-) poles of the battery cell, the assembly process may be a process of forming shapes of battery cells, the activation process may be a process of activating the electrical energy of the battery cell and checking stability, and the pack process may be a process of modularizing the manufactured battery cells and putting the modularized battery cells into a pack.

Among the above processes, the activation process is a process for repeating aging and charging and discharging of the battery cells. The activation process may generally include a process of storing the battery cells at room temperature so that an electrolyte permeates the positive (+) and negative (-) electrodes and when the electrolyte is distributed into the battery cells to smoothly move ions between the positive (+) and negative (-) electrodes, charging and discharging some of the battery cells.

According to the embodiment, the first device 200 can be used in the activation process in the process of manufacturing the battery. In other words, the first device 200 may be one of various devices for driving the activation process. According to the embodiment, the first device 200 may be a storage device or charging/discharging device of the battery cells or may be a separate device provided for communication with the server 100 in the activation process.

The first device 200 may transmit the first data data1 to the server 100. The first device 200 may transmit the first data data1 including first identification information and physical property information of the battery cell to the server 100. Here, the first identification information may include identification numbers of the battery cells. In addition, the physical property information may include an open-circuit voltage) and capacity of the battery cell, but is not limited thereto. In other words, the physical property information included in the first data data1 may include not only the OCV and capacity, but also various information related to the characteristics of the battery cells.

The first device 200 may manufacture a plurality of battery cells, generate the first data data1 corresponding to each battery cell, and continuously transmit the first data data1 corresponding to each battery cell to the server 100. According to another embodiment, the first device 200 can be used in the assembly process in the process of manufacturing the battery.

Meanwhile, the battery cells manufactured by the first device 200 may include identification marks. In other words, the battery cell may include the identification mark on a surface thereof. Here, the identification mark may include a 1-dimensional (1D) barcode. According to the embodiment, the identification mark may include information related to the identification information of the battery cell. In other words, the identification mark may indicate an identification number, which is a unique number of the battery cell.

The pack process in the process of manufacturing the battery is a process of modularizing the battery cells according to models of used places. The pack process may generally include a process of manufacturing a battery pack by forming a plurality of battery cells in a form of cell to cell, fixing the battery cells in a module case, connecting the plurality of battery cells, assembling the module, and connecting the battery cells in a module to module manner.

According to the embodiment, the second device 300 can be used in the pack process in the process of manufacturing the battery. In other words, the second device 300 may be one of various devices for driving the pack process. Since the activation process and the pack process are generally performed in different places, the second device 300 may be disposed in a different place from the first device 200.

The second device 300 may identify the identification marks included in the battery cells. Since the second device 300 is included in the pack process and the pack process is performed after the assembly process and the activation process, the battery cells identified by the second device 300 may include the identification marks. Therefore, the second device 300 may acquire the information about the battery cell by identifying the identification mark disposed on the surfaces of the battery cell. In other words, the second device 300 may acquire identification information of the battery cell by identifying the identification mark.

The second device 300 may generate the second data data2 based on the identification information acquired by identifying the battery cell. Therefore, the second data data2 may include identification information obtained by the second device 300 by identifying the identification mark of the battery cell. Identification information included in the second data data2 can be defined as second identification information. In other words, the second device 300 may generate the second data data2 including the second identification information of the battery cell. In addition, the second device 300 may transmit the second data data2 to the server 100.

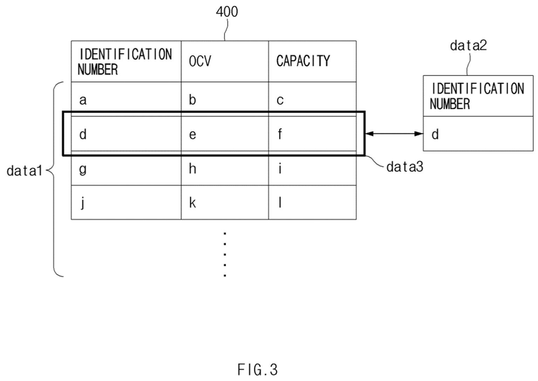

The second device 300 may receive third data data3 from the server 100. The third data data3 may include the identification information and physical property information of the battery cell. In other words, the third data data3 may include the identification information of the battery cell and the OCV and capacity of the battery cell or include a loss signal. Here, the identification information included in the third data data3 may be the same as the identification information included in the second data data2. In other words, the second device 300 may acquire the second identification information by recognizing the identification mark of the battery cell and acquire the physical property information of the battery cell by receiving the third data data3 from the server 100. The third data data3 will be specifically described below with reference to FIG.3.

The second device 300 may analyze the third data data3. According to the embodiment, when the third data data3 includes the identification information, OCV, and capacity of the battery cell, the second device 300 may extract the second identification information corresponding to the identification information included in the third data data3 and match the third data data3 with the battery cell which is the basis of the second identification information. Therefore, the second device 300 may acquire information about the battery cell based on the third data data3. In other words, the second device 300 may regard the identification information, OCV, and capacity of the battery cell included in the third data data3 as the information about the battery cell which is the basis of the second data data2.

According to the embodiment, when the third data data3 includes the loss signal, the second device 300 may record a loss of the information about the battery cell and display the loss of the information about the battery cell by allowing a user to check the loss of the information about the battery cell.

FIG.2 is a view showing a server according to one embodiment disclosed herein. FIG.3 is a view showing a method in which the server according to one embodiment disclosed herein matches first data with second data.

First, referring to FIG.2, the server 100 may include a communication unit 110, a controller 120, and a storage 130. The communication unit 110 may communicate with other devices not included in the server 100. According to the embodiment, the communication unit 110 may transmit and receive data with the first device 200 and the second device 300. Specifically, the communication unit 110 may receive the first data data1 from the first device 200. The communication unit 110 may transmit the first data data1 received from the first device 200 to the controller 120. In addition, the communication unit 110 may receive the second data data2 from the second device 300. The communication unit 110 may transmit the second data data2 received from the second device 300 to the controller 120.

The communication unit 110 may transmit the third data data3 to the second device 300. In other words, the communication unit 110 may receive the third data data3 from the controller 120 and transmit the third data data3 to the second device 300.

Referring to FIGS. 2 and 3, the controller 120 may generate the database 400 based on the first data data1. First, the controller 120 may receive a plurality of pieces of first data data1 from the communication unit 110. The controller 120 may generate the database 400 by dividing each of the plurality of pieces of first data data1 received from the communication unit 110. In other words, the database 400 may include the plurality of pieces of first data data1 and separately store the identification information, OCV, and capacity included in each first data data1. According to the embodiment, the database 400 may be a lookup table.

The controller 120 may receive the second data data2 from the communication unit 110. The controller 120 may compare the database 400 with the second data data2. According to the embodiment, the controller 120 may determine whether the first data data1 corresponding to the second data data2 among the plurality of pieces of first data data1 included in the database 400 is present. To this end, the controller 120 may compare the first identification information of each of the plurality of pieces of first data data1 included in the database 400 with the second identification information included in the second data data2. According to the embodiment, when extracting the first identification information which is the same as the second identification information, the controller 120 can define the first data data1 including the corresponding first identification information as the third data data3.

When the controller 120 fails to find the first identification information which is the same as the second identification information, the controller 120 may define the loss signal as the third data data3.

The controller 120 may transmit the third data data3 to the second device 300. Specifically, the controller 120 may transmit the third data data3 to the communication unit 110 and control the communication unit 110 to transmit the third data data3 to the second device 300. Here, the third data data3 may include the identification information, the OCV, and the capacity or the loss signal.

Referring back to FIG.2, the storage 130 may store the first data data1. The storage 130 may receive the first data data1 from the communication unit 110 and store the first data data1. According to the embodiment, the storage 130 may receive the database 400 from the controller 120 and store the database 400.

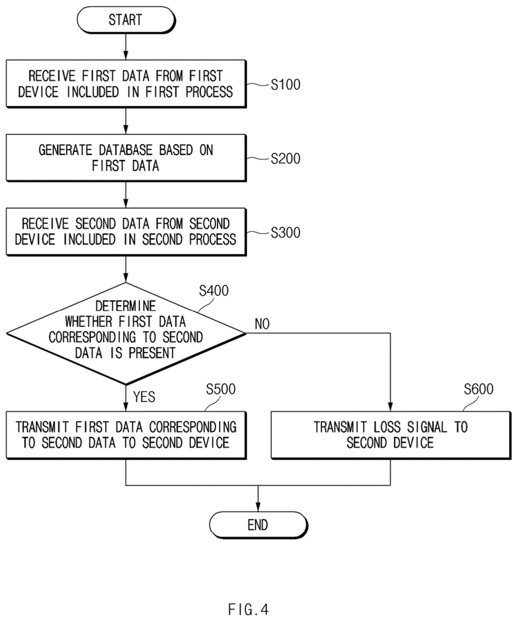

FIG.4 is a flowchart showing a method of operating the server according to one embodiment disclosed herein.

The embodiment illustrated in FIG.4 is only one embodiment, the order of operations according to various embodiments of the present invention may be different from that illustrated in FIG.4, and some operations illustrated in FIG.4 may be omitted, the order between the operations may be changed, or the operations may be merged.

Referring to FIG.4, the method of operating the server may include an operation of receiving first data from a first device included in a first process (S100), an operation of generating a database based on first data (S200), an operation of receiving second data from a second device included in a second process (S300), an operation of determining whether the first data corresponding to the second data is present (S400), an operation of transmitting the first data corresponding to the second data to the second device (S500), and an operation of transmitting a loss signal to the second device (S600).

Hereinafter, operations S100 to S600 will be described in detail with reference to FIGS. 1 to 3.

In operation S100, the server 100 may receive the first data data1 from the first device 200 included in the first process. The server 100 may receive the first data data1 from the first device 200 and store the first data data1. Here, the first device 200 may include a device for manufacturing a battery. A process of manufacturing the battery may include an electrode process, an assembly process, an activation process, and a pack process. According to the embodiment, the first device 200 can be used in the activation process in the process of manufacturing the battery. In other words, the first device 200 may be one of various devices for driving the activation process. In addition, the first data data1 may include the identification information, OCV, and capacity of the battery cell.

In operation S200, the server 100 may generate the database 400 based on the first data data1.

The server 100 may generate the database 400 by dividing the plurality of pieces of first data data1 received from the first device 200. In other words, the database 400 may include the plurality of pieces of first data data1 and separately store the identification information, OCV, and capacity included in each first data data1. According to the embodiment, the database 400 may be a lookup table.

In operation S300, the server 100 may receive the second data data2 from the second device 300 included in the second process. Here, the second device 300 may include a device for manufacturing a battery. According to the embodiment, the second device 300 can be used in the pack process in the process of manufacturing the battery. In other words, the second device 300 may be one of various devices for driving the pack process. Since the assembly process, the activation process, and the pack process of are generally performed in different places, the second device 300 may be disposed in a different place from the first device 200.

The server 100 may receive the second data data2 including the identification information of the battery cell acquired by identifying the identification mark disposed on the surface of the battery cell by the second device 300.

In operation S400, the server 100 may determine whether the first data data1 corresponding to the second data data2 is present. The server 100 may compare the database 400 with the second data data2. According to the embodiment, the server 100 may determine whether the first data data1 corresponding to the second data data2 among the plurality of pieces of first data data1 included in the database 400 is present. To this end, the server 100 may compare the first identification information of each of the plurality of pieces of first data data1 included in the database 400 with the second identification information included in the second data data2.

When the server 100 determines that the first data data1 corresponding to the second data data2 is present in the database 400, operation S500 may be performed. When the server 100 determines that the first data data1 corresponding to the second data data2 is not present in the database 400, operation S600 may be performed.

In operation S500, the server 100 may transmit the first data data1 corresponding to the second data data2 to the second device 300. According to the embodiment, when extracting the first identification information which is the same as the second identification information, the server 100 can define the first data data1 including the corresponding first identification information as the third data data3. The server 100 may transmit the third data data3 to the second device 300. Here, the third data data3 may include the first data data1.

In operation S600, the server 100 may transmit the loss signal to the second device 300. According to the embodiment, when the server 100 fails to find the first identification information which is the same as the second identification information, the server 100 can define the loss signal as the third data data3. The server 100 may transmit the third data data3 to the second device 300. Here, the third data data3 may include the loss signal.

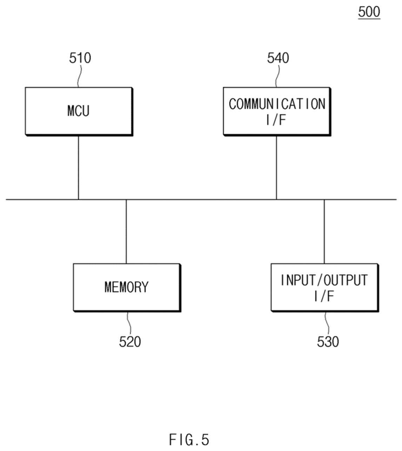

FIG.5 is a computing system for executing the method of operating the server according to one embodiment disclosed herein.

Referring to FIG.5, a computing system 500 according to one embodiment disclosed herein may include a micro controller unit (MCU) 510, a memory 520, an input/output I/F 530, and a communication I/F 540.

The MCU 510 may be a processor for executing various programs (e.g., a state of health (SOH) calculation program and a cell balancing execution target determination program) stored in the memory 520, processing various pieces of data including states of charge (SOCs), SOHs, and the like of the plurality of battery cells through the programs, and performing functions of the server 100 described above with reference to FIGS. 1 to 4.

The memory 520 may store various programs related to calculating the SOH of the battery cell and determining a cell balancing execution target. In addition, the memory 520 may store various pieces of data such as SOC and SOH data of each battery cell.

A plurality of memories 520 may also be provided if necessary. The memory 520 may be a volatile memory or a non-volatile memory. As the memory 520 of the volatile memory, a RAM, a DRAM, a SRAM, or the like can be used. As the memory 520 of the non-volatile memory, a ROM, a PROM, an EAROM, an EPROM, an EEPROM, a flash memory, or the like can be used. Examples of the above-listed memories 520 are merely illustrative and are not limited to these examples.

The input/output I/F 530 may be an interface for connecting an input device (not shown), such as a keyboard, a mouse, or a touch panel, and an output device, such as a display (not shown) with the MCU 510 and allowing the input and output devices and the MCU 510 to transmit and receive data.

The communication I/F 540 is a component capable of transmitting and receiving various data to and from the server and may be various devices capable of supporting wired or wireless communication. For example, a program, various pieces of data, or the like for calculating the SOH of the battery cell or determining the balancing target may be transmitted and received from a separately provided external server through the communication I/F 540.

As described above, the method of operating the server according to one embodiment disclosed herein may be recorded in the memory 520 and executed by the MCU 510.

The above description is merely the exemplary description of the technical spirit disclosed herein, and those skilled in the art to which embodiments disclosed herein pertain will be able to variously modify and change the present disclosure without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. A server comprising:
a communication unit configured to receive first data including first identification information and physical property information of a battery cell from a first device included in a first process in a process of manufacturing the battery cell, and receive second data including second identification information of the battery cell from a second device included in a second process which differs from the first process; and
a controller configured to identify the first data corresponding to the second data based on the first identification information and the second identification information, and transmit the first data to the second device.

2. The server of claim 1, wherein the controller determines that the second data corresponds to the first data when the second identification information and the first identification information are the same.

3. The server of claim 1, wherein the second device acquires the second identification information by recognizing an identification mark included in the battery cell.

4. The server of claim 3, wherein the identification mark is a 1-dimensional (1D) barcode.

5. The server of claim 3, wherein the second device acquires the physical property information by receiving data from the communication unit.

6. The server of claim 1, wherein the first identification information includes an identification number of the battery cell, and
the physical property information includes an open-circuit voltage (OCV) and capacity of the battery cell.

7. The server of claim 6, wherein the second identification information includes the identification number of the battery cell.

8. The server of claim 7, wherein the controller is configured to:
generate a database including the first data;
transmit the first data including the first identification information to the second device when the database includes the first identification information corresponding to the second identification information; and
transmit a loss signal to the second device when the database does not include the first identification information corresponding to the second identification information.

9. The server of claim 1, wherein the first process is an assembly process or an activation process, and the second process is a pack process.

10. The server of claim 1, further comprising a storage configured to store the first data.

11. A method of manufacturing a battery, comprising:
receiving first data including first identification information and physical property information of a battery cell from a first device included in a first process in a process of manufacturing the battery cell;
receiving second data including second identification information and physical property information of the battery cell from a second device included in a second process which differs from the first process; and
transmitting the first data corresponding to the second data to the second device.

12. The method of claim 11, further comprising identifying the first data corresponding to the second data.

13. The method of claim 12, wherein the identifying includes determining that the second data corresponds to the first data when the second identification number and the first identification number are the same.

14. The method of claim 11, wherein the second device acquires the second identification information by recognizing an identification mark included in the battery cell.

15. The method of claim 14, wherein the identification mark is a 1-dimensional (1D) barcode.

16. The method of claim 11, wherein the first identification information includes an identification number of the battery cell, and
the physical property information includes an open-circuit voltage (OCV) and capacity of the battery cell.

17. The method of claim 16, wherein the second identification information includes the identification number of the battery cell.

18. The method of claim 11, wherein the first process is an assembly process or an activation process, and the second process is a pack process.
